# EUROPÄISCHE PATENTSCHRIFT

(11) **EP 0 786 930 B1**
(45) Veröffentlichungstag und Bekanntmachung des Hinweises auf die Patenterteilung: **28.10.1998**
(21) Anmeldenummer: 97100740.6
(22) Anmeldetag: 17.01.1997
(51) Int. Cl.: H05K 7/20

(54) **Gehäuse für einen flachen Lüftereinschub**
Housing for a flat drawer with a fan
Boîtier pour un tiroir plat avec un ventilateur

(30) Priorität: 23.01.1996 DE 19602338
(43) Veröffentlichungstag der Anmeldung: 30.07.1997
(73) Patentinhaber: SIEMENS AKTIENGESELLSCHAFT, 80333 München (DE)
(72) Erfinder: Szybalski, Michael, 12169 Berlin (DE); Neubarth, Alexander, 17489 Greifswald (DE)

(56) Entgegenhaltungen:
- EP-A- 0 470 926
- DE-U- 9 014 160
- FR-A- 2 570 920
- US-A- 3 868 158

## Beschreibung

Die Erfindung bezieht sich auf ein Gehäuse eines flachen Lüftereinschubs zum Einsetzen in einen Baugruppenrahmen.

Ein derartiges Gehäuse ist z.B. durch das "Produkthandbuch`95" D 6/93 6/30 (39600-200) der Fa. VERO-Electronics GmbH, Bremen, S. 2.62 sowie durch die Firmenschrift "Wir geben Elektronik Gestalt" der Fa. Schroff GmbH, Feldrennach, S. 15.02, 15.04, 15.11, 15.17 bekannt geworden. Danach besteht das Gehäuse aus einem flachen, allseitig geschlossenen Kasten, an den bedienungsseitig eine verstärkte Frontplatte angesetzt ist. Ein derartiger Lüftereinschub ist ähnlich wie eine Baugruppe in den Baugruppenrahmen einsetzbar. Die großflächigen Seitenwände des Kastens sind gitterartig mit Löchern zum Luftdurchtritt versehen. Der Kasten ist aus zwei Teilen zusammengesetzt. Ein erstes wannenartiges Gehäuseteil besteht aus einer der Seitenwände und umlaufend ringsum hochgebogenen Stegen, an die die andere Seitenwand angesetzt ist. Das Gehäuse des Lüftereinschubs besteht also insgesamt aus drei Teilen, nämlich der Frontplatte, dem wannenartigen Gehäuseteil mit einer der Seitenwände und der anderen Seitenwand.

Der Erfindung liegt die Aufgabe zugrunde, den Herstellungsaufwand für das Gehäuse zu verringern.

Diese Aufgabe wird durch die Erfindung gemäß Anspruch 1 gelöst. Danach besteht nun das Gehäuse aus einem einzigen Blechteil, von der Stärke der Frontplatte. Das bedeutet, daß für die Seitenwände mehr Material benötigt wird. Dieser geringe Mehraufwand wird jedoch durch die einfachere Herstellung und Montage des Gehäuses weit überkompensiert. Bei der Herstellung sind lediglich zwei Biegungen entlang den Seitenkanten der Frontplatte erforderlich. Es entfällt das separate Zuschneiden der Frontplatte, des wannenartigen Gehäuseteils und der anderen Seitenwand sowie das Zusammenschrauben dieser Teile. Durch die Verwendung des verstärken Materials wird das Gehäuse in sich so stabil, daß keine weiteren Versteifungsmittel erforderlich sind. Die Lüfter können einfach zwischen die beiden Seitenwände geschoben und an einer der Seitenwände angeschraubt werden. Die andere Seitenwand stellt dann lediglich einen Berührungsschutz dar.

Durch die Weiterbildung nach Anspruch 2 kann das Gehäuse soweit verstärkt werden, daß ein Einsatz in mobilen Objekten mit starken Erschütterungen möglich ist.

Die Weiterbildung nach Anspruch 3 wird dadurch begünstigt, daß die Rückseite des Gehäuses offen ist, so daß die Steuereinheit ungehindert mit den Lüftern verbunden werden kann.

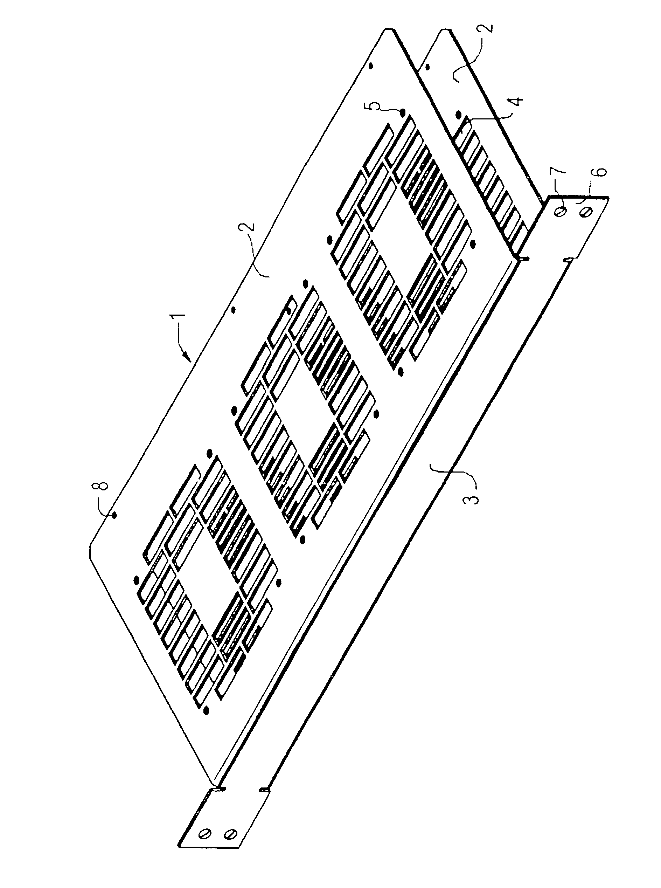

Im folgenden wird die Erfindung anhand eines in der Zeichnung dargestellten Ausführungsbeispieles näher erläutert.

Die dargestellte Figur zeigt perspektivisch ein Gehäuse 1 eines Lüftereinschubs, der in einen Baugruppenrahmen einsetzbar ist. Das Gehäuse besteht aus einem u-förmig gebogenen Blech, bei dem die Seitenschenkel als Seitenwände 2 und die Basis als Frontplatte 3 ausgebildet sind. Die Seitenwände weisen gitterartige Lochgruppen 4 für jeweils einen Lüfter auf. Im Randbereich der Lochgruppen sind Befestigungslöcher 5 für die einzusetzenden nicht dargestellten Lüfter vorgesehen. Das verwendete Blech ist so dick, daß eine nur einseitige Befestigung der Lüfter an nur einer der Seitenwände 2 möglich ist.

Entlang der der Frontplatte 3 gegenüberliegenden rückseitigen Längskante sind in der Seitenwand als Montagelöcher 8 ausgebildete Befestigungsformen vorgesehen, die der Befestigung eines zusätzlichen Bauteils, z.B. einer Steuereinheit für die Lüfter dienen.

## Patentansprüche

1. Gehäuse (1) eines flachen Lüftereinschubs zum Einsetzen in einen Baugruppenrahmen mit einer bedienungsseitigen schmalen Frontplatte (3) und zwei an dieser längsseitig angesetzten senkrechtstehenden Seitenwänden (2),
**dadurch gekennzeichnet,**
daß die Frontplatte (3) und die Seitenwände (2) einstückig aus einem U-förmig gebogenen Blech bestehen.

2. Gehäuse nach Anspruch 1,
**dadurch gekennzeichnet,**
daß die Seitenwände (2) durch schraubenartige Befestigungselemente miteinander verbindbar sind.

3. Gehäuse nach Anspruch 1 oder 2,
**dadurch gekennzeichnet,**
daß die Seitenwände (2) entlang ihrer der Frontplatte (3) gegenüberliegenden rückseitigen Längskante mit Befestigungsformen (8) zum rückseitigen Ansetzen einer zusätzlichen Baueinheit aufweisen.

## Claims

1. Housing (1) of a flat fan drawer for insertion into a subassembly frame, with a narrow front plate (3) located on the operator's side and with two perpendicular side walls (2) attached longitudinally thereto, characterized in that the front plate (3) and the side walls (2) consist, in one piece, of a metal sheet bent in a U-shaped manner.

2. Housing according to Claim 1, characterized in that the side walls (2) can be connected to one another by means of screw-like fastening elements.

3. Housing according to Claim 1 or 2, characterized in that, along their rear longitudinal edge located opposite the front plate (3), the side walls (2) have forms of fastening (8) for the rear attachment of an additional structural unit.

## Revendications

1. Boîtier (1) d'un tiroir plat équipé de ventilateurs à insérer dans un châssis de modules, comprenant une étroite plaque (3) frontale côté utilisateur, et deux parois (2) latérales rapportées perpendiculairement à cette plaque sur ses côtés longitudinaux,
**caractérisé** en ce que la plaque (3) frontale et les parois (2) latérales sont constituées, d'un seul tenant, d'une tôle repliée en forme de U.

2. Boîtier suivant la revendication 1, **caractérisé** en ce que les parois (2) latérales peuvent être mutuellement reliées par des éléments de fixation du genre vis.

3. Boîtier suivant la revendication 1 ou 2, **caractérisé** en ce que les parois (2) latérales comportent, le long de leur bord longitudinal arrière, opposé à la plaque (3) frontale, des conformations (8) de fixation pour monter sur le côté arrière un composant supplémentaire.
